# EUROPEAN PATENT SPECIFICATION

(11) **EP 2 266 195 B1**
(45) Date of publication and mention of the grant of the patent: **20.12.2017**
(21) Application number: 09723690.5
(22) Date of filing: 23.03.2009
(51) Int. Cl.: H02M 1/32, H03K 17/082

(54) **HANDLING OF SHORT CIRCUIT SITUATION IN CONVERTERS**
BETRIEBSVERFAHREN FÜR KURZSCHLUSSSITUATIONEN IN UMWANDLERN
GESTION D'UNE SITUATION DE COURT-CIRCUIT DANS DES CONVERTISSEURS

(30) Priority: 28.03.2008 GB 0805739
(43) Date of publication of application: 29.12.2010
(73) Proprietor: Bombardier Transportation GmbH, 10785 Berlin (DE)
(72) Inventor: WENNERLUND, Per, 72226 Västeras (SE); BELWON, Waldemar, A., 72241 Västeras (SE); OLIN, Kurt, 73-061 Virsbo (SE)
(74) Representative: Patentanwälte Bressel und Partner mbB
(86) International application number: PCT/EP2009/002421
(87) International publication number: WO 2009/118201

(56) References cited:
- US-A- 4 761 702
- US-A- 5 621 622
- US-A- 5 796 597
- US-A1- 2004 251 884

## Description

The present invention relates to a method of operating an electronic valve, in particular a valve in a converter (preferably a high power converter), wherein the valve comprises an electrically insulated control electrode. The present invention also relates to an arrangement for operating such an electronic valve. In particular, the present invention relates to the handling of short-circuit situations in converters having at least one phase leg.

A phase leg is understood to be a series connection of two electronic valves which can be switched on and switched off. The converter (in particular a power converter which may be connected to voltages of more than 600 volt) may be a motor inverter, a line converter, a generator converter, a battery charger or an auxiliary inverter, for example. In particular, these types of converters refer to the delivery of electric energy to devices in railway vehicles, for example in propulsion units of railway vehicles. In this case, a motor inverter is understood to be a converter which inverts a direct current to an alternating current, wherein the alternating current is directly fed to the motor. The motor may be, for example, the propulsion motor which causes movement of the railway vehicle on the rail or rails. A line converter is understood to be an AC to DC converter, wherein the line of an electric power supply network carries an alternating current. A generator converter is understood to be an AC to DC converter for rectifying the three phase AC supply from a generator driven by a combustion motor and forming a regulated DC voltage. The DC side of the line converter or generator converter may be connected to a DC-link which in turn may be connected to the motor inverter. An auxiliary converter may be an inverter which can be, for example, connected to the DC-link, wherein the alternating current side of the inverter is connected to auxiliary devices of the railway vehicle, such as any devices which are not directly used to cause movement of the railway vehicle. Examples of auxiliary devices are cooling devices, control devices and compartment heating devices.

Converters usually have one feature in common, namely that their valves are controlled (and thereby switched on and off) with a very high frequency, i. e. the control units and devices operate at high speed, preferably with reaction times within the nanosecond range.

There are different types of short circuit situations in converters. In all of these situations, at least one the valves in the phase leg needs to be switched off in order to prevent further damage. In particular, the valve itself and/or the electric connections to and from the valve can be destroyed.

According to a first type of short circuit situations one of the valves in a phase leg is either conducting the load current or is bridged by an un-intended conduction path carrying the load current when the other valve in the same phase leg is brought into the conducting condition (the "ON"-state), for example due to inappropriate timing of the on-signals and off-signals the valves. The result may be that the high potential line and the low potential line of a DC-link which is connected by the phase leg are short-circuited and, as a result, the current through the phase leg is rising within very short time to values exceeding the maximum allowed values of the valves. However, in this type of situation, the increase of the current per time unit is usually smaller than in other short circuit situations, since the control unit which controls the switching on process usually opens the valve gradually. Therefore, the short circuit can be detected in a stage of the opening process in which the current has not reached extremely high values.

In a second type of short circuit situations one of the valves in the phase leg carries a load current when the other valve in the phase leg is damaged so that it produces a short-circuited connection to the end of the phase leg. In this case, the increase of the current through the non-damaged valve of the phase leg can be much higher per time unit than the situations of the first type.

In a third type of short circuit situations, a free wheeling diode parallel to a first valve in the phase leg is carrying a load current, when the other valve in the phase leg is damaged and produces a short circuit. Although the current through the non-damaged valve needs to be reversed, first, the increase of the reversed current can be as high as in the second type of situations per time unit.

Existing methods of handling short circuit situations include the monitoring of electric quantities, such as the valve current (i.e. the current which is carried by the valve), the valve voltage (e.g. the collector emitter voltage of an IGBT), the increase of the valve current per time unit. Also, the operating state of the valve control units which control the control electrodes of the valves can be monitored. If a pre-defined condition or set of conditions is fulfilled (for ex-ample, the valve current exceeds a pre-defined threshold value) the control unit of the valve operates the control electrode of the valve in such a manner that the valve is switched off.

It is possible that the pre-defined condition or conditions are fulfilled, although there is no short circuit situation. A possible reason for this is that external electromagnetic fields induce a current in the phase leg or induces a voltage or a current in the circuits of the monitoring device for a short period of time. Such an event can be called "noise". Therefore, existing methods of handling short circuit situations include the step of monitoring if the pre-defined condition or conditions is/are fulfilled over a time period of pre-defined length. The process of closing the valve is only started if the pre-defined condition or conditions continue over the pre-defined time interval. Then, the process of switching off the valve is latched, i.e. the process proceeds until the valve is switched off, no matter if the pre-defined condition or conditions continue. One reason for the latching is that the short circuit situation may continue, although the pre-defined condition or conditions are no longer fulfilled. For example, the increase of the valve current per time unit may become smaller, while the current is still increasing.

Recently, new types of valves, in particular IGBTs (insulated gate bipolar transistors) have been developed which are designed for the operation using significantly higher external voltages. For example, the DC-link voltage across the phase leg may be in the range of more than 1500 volt. This new type of valves has, on the other hand, the drawback that for the second and third type of short circuit situations it does not (using conventional methods of handling the short circuit situation) limit the valve current to a safe value. Instead, the manufacturer of the valve specifies that the maximum current may not exceed a specified maximum value for longer than a specified time. Using the short circuit handling procedure described above, this specification cannot be met, at least in some short circuit situations.

US 5,621,622 describes an overload protection for an AC/DC converter. Upon the occurrence of a short circuit or a current overload, a circuit core becomes saturated, ceasing operation of the step-down/isolator until the short or the connected device drawing the current overload is removed.

US 5,796,597 discloses a switch mode power supply apparatus comprising a first transistor switch coupled to an inductance and responsive to a periodic switch control signal for generating current pulses in said inductance. The apparatus further comprises an over-current protection circuit responsive to said current pulse indicative signal for disabling said power supply output when an over-current condition occurs.

It is an object of the invention to provide a method of operating a valve in a converter which protects the valve from damage and which does not increase the probability that the valve is switched off unnecessarily. Such an unnecessary switching off would interfere with the demand that the converter should work reliably as long as possible. For example, a motor converter which is unnecessarily switched off may cause jerks of the rail vehicle or bucking of the motor. It is another object of the invention to provide an arrangement which corresponds to the method, in particular which performs the method.

The objects are solved by the subject-matter of the attached independent claims 1 and 9.

It is one basic idea of the present invention to monitor the operation of the valve and/or the converter and to start a pre-termination procedure when specific, pre-defined operating conditions occur, before a final termination procedure is started. "Termination" in this context means terminating the ON-state (i.e. the conducting state) of the valve. Note that starting the pre-termination procedure does not necessarily result in starting the final termination procedure. For example, the final termination procedure may be the procedure of handling short circuit situations as described above.

In particular, the pre-termination procedure may include the step of monitoring if pre-defined condition or conditions is/are met (i.e. fulfilled) over a time interval of pre-defined length. This pre-defined length is shorter than the time period (if any) of the final termination procedure, wherein the condition or conditions for starting the final termination procedure must continue to be fulfilled during the time period. Alternatively the pre-defined condition or conditions for pre-termination may be such that they are more easily (e.g. more often and/or earlier) met than that/those for the final termination process.

More generally speaking the pre-termination procedure can be started earlier than the final termination procedure. In particular, the pre-termination procedure prepares the termination of the ON-state of the valve, but does not terminate the ON-state. On the other hand, the pre-termination procedure accelerates the termination of the ON-state, if the final termination procedure is actually started. The final termination procedure may be a procedure which is performed until the termination of the ON-state is finalized, once the final termination procedure has been started. Such a latching is described above.

If no final termination procedure is started after a pre-termination procedure, the normal ON-state will resume.

The pre-termination procedure according to the present invention is particularly useful if the valve is operated as follows: typically, the electric potential at the control electrode of the valve has a defined level (e.g. 11 to 12 V) which is sufficiently high so that the valve can carry the specified maximum current which is required for normal operation. However, it is common practice to use a higher potential of the control electrode (e.g. 15 V) to reduce the voltage across the valve during the ON-state (e.g. the collector-emitter voltage of an IGBT or MOSFET (metal oxid semi-conductor field effect transistor). This excess of the gate potential corresponds to an excess of the electric charge carried by the control electrode (e.g. the gate of the IGBT or MOSFET). In a specific embodiment, the pre-termination procedure is de-signed to remove the excess electric charge from the control electrode. The result may be that the electric losses during operation of the valve after the pre-termination procedure are slightly increased temporarily. However, the valve is still capable of carrying the maximum current required for normal operation. In the case of a short circuit, the excess charge which is removed by the pre-termination procedure from the control electrode will accelerate the final termination procedure, which may be started after the pre-termination procedure. If the pre-termination was caused by noise no final termination procedure is started and the normal ON-state will resume, resulting in normal gate voltage and normal losses of electric energy after a short time.

Since the valve is part of a phase leg of a converter, the valve is repeatedly switched on and switched off during normal operation of the converter. Therefore, if no final termination procedure is started after a pre-termination procedure, a normal termination procedure (i.e. a process of switching off the valve) will follow and also a normal procedure of switching on the valve will follow. After being switched off and on again, the control electrode of the valve may carry an excess charge again, as described above.

It has been mentioned before that the valve may be an IGBT or MOSFET. Generally, the present invention relates to any valve type which can be used in converters wherein the valve has an electrically insulated control electrode and wherein the charge carried by the control electrode controls the operating state (e.g. the ON-state or OFF-state) of the valve. If words like "emitter", "gate" and "collector" are used in this description, this does not limit the scope of protection, unless explicitly stated. For example, valves having electrodes which are usually named Drain and Source are also included.

One embodiment which has the advantage that just the excess charge of the control electrode is removed during pre-termination, includes the step of discharging the control electrode with a constant (not time varying) current over a time interval of pre-defined length. The level of the constant current and the length of the time interval may be chosen in such a manner that the excess charge is removed only or that not more than the excess charge is removed (which includes the case that less than the excess charge is removed). The values for the constant current and the length of the time interval may be chosen for specific operating conditions, such as a pre-defined maximum valve current which is carried by the valve during normal operation of the converter and/or for a specified DC-link voltage across the phase leg of the valve.

In particular, the following is proposed: A method of operating an electronic valve in a converter, in particular a high power converter, wherein the valve comprises an electrically insulated control electrode and wherein the method comprises the steps:
- an operating state of the converter and/or of the valve is/are monitored while the valve is open,
- if the operating state fulfils a first pre-defined criterion, indicating that there is a short circuit which affects a current through the valve, a first process of de-charging the control electrode is performed in order to close the valve (i.e. bring the valve into the non-conductive state), and
- if the operating state fulfils a second pre-defined criterion, indicating that there may be a short circuit which affects a current through the valve, a second process of de-charging the control electrode is performed before the first criterion is fulfilled.

Alternatively, the time period during which the second process is performed, ends before the first process is started.

The second process of de-charging the control electrode is performed before the first criterion (the criterion of the final termination process) is fulfilled or the second process is performed before the first process is started. In the latter case, the first criterion may already be fulfilled, but the first process is not started yet. In other words: the pre-termination may "override" the final termination. Both processes, the first and the second process, may be pre-defined processes. However, the operation of the pre-defined processes may depend on the operating state of the valve or of the converter. For example, the first process may be pre-defined to reduce the current which discharges the control electrode gradually depending on the voltage across the valve (e.g. the collector-emitter voltage). It is also possible that the second process is performed independently from the operating state of the valve or of the converter or that the size of the current which discharges the control electrode during the second process is constant and that the only way of reacting to a new operating state during the second process is to terminate the discharging of the control electrode earlier than intended at the beginning of the second process.

It is also possible that the second process is interrupted or is performed more than one time before the first process is started. For example, the second process may include the step of continuously monitoring the operating state of the valve or of the converter while the control electrode is discharged. If the monitoring indicates that the second process should be stopped (e.g. because the increase of the valve current per time unit has fallen below a threshold value), the second process, i.e. the discharging of the control electrode, may be stopped. However, during the following time period the monitoring function of the second process may decide that the second process may be re-started or may be continued and, as a result, the discharging of the control electrode is re-started or continued, before the first process is started.

The first pre-defined criterion and the second pre-defined criterion each may comprise one or more than one criteria and/or conditions. In particular, the criterion may comprise the condition that an electric quantity which characterises the operating state of the converter and/or of the valve is within a pre-defined range of values, is greater than (or greater than or equal) a pre-defined threshold value or is smaller than (or smaller than or equal) a pre-defined threshold value. Conditions for the first criterion are mentioned above.

Conditions for the second pre-defined criterion may comprise the condition that the increase of the valve current per time unit is not greater than (or not greater than or equal) a threshold value. This condition is an indicator for a short circuit, since high increases during the ON-state of the valve (i.e. after the process of switching on the valve has terminated) are unexpected. This condition can be combined with at least one other condition, such as the condition that the control electrode carries an excess amount of charge described above. Such an excess amount can be detected by measuring the voltage between the control electrode and another electrode of the valve, for example between gate and emitter of an IGBT. Since it is an advantage of a preferred embodiment of the invention to remove an excess charge carried by the control electrode during the pre-termination, the condition described before is valuable.

Instead of the conditions described in the previous paragraph, other conditions can be used for the second pre-defined criterion. In principle, it is also possible to use electric quantities which are measured not directly at the valve itself, but, for example, measured in a connection which connects the two valves of the same phase leg. However, the measurement of electric quantities directly at the valve is preferred, since the information contained in the measurement result directly characterises the operating state of the valve and since these measurements can be made by a control unit which is assigned to the valve (such as a gate drive unit, GDU) and which also controls the process of charging and discharging the control electrode.

Since a main advantage of the pre-termination is that the valve can be protected against damage, the second pre-defined criterion is a criterion indicating that there may be a short circuit which affects a current through the valve, namely the valve current (e.g. the current from the collector to the emitter of an IGBT). The effect in question which may be caused by the short circuit (e.g. the damage of other valve of the same phase leg) is in cases of the second type of short circuit situations (as explained above) that the load current carried by the valve increases rapidly. In case of the third type of short circuit situations, the effect is first a reverse of the current and than a rapid increase of the valve current.

It is not the purpose of the second process to close the valve. A closed valve is understood to be a valve which does not carry a current (an OFF-state current is not considered to be a relevant current in this context), and, in particular, does not carry a load current. The aim of the second process is just to prepare and/or to accelerate the first process of de-charging the control electrode which is the process of closing the valve, provided that the first pre-defined criterion is fulfilled.

It is possible that the first process directly begins when the second process has terminated. In other words: there might be no time gap between the first process and the second process. Therefore, it may happen that the second process cannot be completed in a manner which would have been the case if the first pre-defined criterion were not fulfilled. Furthermore, it may happen that the first pre-defined criterion is fulfilled already, but the second process still continues.

However, the second process (the pre-termination) may alternatively be designed to terminate before the first pre-defined criterion may be fulfilled. In this case, the second process terminates and is followed by a time interval where no active discharging of the control electrode takes place, before the first pre-defined criterion is fulfilled and the first process starts. The advantage of having such a time gap between the second process and the first process is that the second process can be performed exactly as intended. Furthermore, the result of the second process can be observed by monitoring the operating state of the converter and it may be the case that the second process influences the operating state in such a manner that the first pre-defined criterion is not fulfilled. This applies particularly to situations where a short circuit does not occur, but the more sensitive second pre-defined criterion is fulfilled.

Preferably, the second process is designed to withdraw a pre-defined amount of charge from the control electrode. For example, this can be achieved by using a constant discharging current and by terminating the second process when a time interval of pre-defined length has elapsed. However, the pre-defined amount of charge can also be achieved by a discharging current which varies during the course of the second process.

In addition, it is preferred (as described above) that the second process withdraws an amount of charge from the control electrode which does not reduce the current through the valve during normal, non-short-circuit operating conditions of the valve. This means that the maximum possible valve current which may occur during normal operating conditions can still pass the valve when the second process has terminated. On the other hand, a significantly increased valve current will be affected by the reduced gate charge, i.e. the increase of the current due to a short circuit can be limited.

In order to reduce the number of unnecessary discharging operations, it is preferred that the second process of de-charging the control electrode is performed only if the operating state fulfils the second pre-defined criterion over a time interval of pre-defined length. Alternatively, electric quantities which are used to determine whether the second pre-defined criterion is fulfilled or not, can be filtered to exclude that transient behaviour due to noise results in the start of a second process.

It may happen that it turns out during the execution of the second process that there is no short circuit situation. Therefore, according to another embodiment, the second process of de-charging the control electrode may immediately be terminated if the operating state fulfils a third pre-defined criterion, indicating that there is no short circuit which affects a current through the valve.

Alternatively, the second process of de-charging the control electrode may be terminated if the operating state fulfils a third pre-defined criterion over a time interval of pre-defined length, indicating that there is no short circuit which affects a current through the valve. Instead of using such a time interval of pre-defined length, a filtering of corresponding quantities is possible. The purpose is to avoid an unnecessary and false interruption of the second process. For example, a single measurement value of the increase of the valve current per time unit may indicate that there is no short circuit. However, this single measurement value might be the result of noise or interference and the following measurement values of the increase of the valve current per time unit are exceeding the threshold value again which is used to determine the second pre-defined criterion.

For example, the third pre-defined criterion may be the condition that the increase of the valve current per time unit has fallen below a threshold value which may be the same threshold value or may be another, lower threshold value as the threshold value which is used for the second pre-defined criterion.

It is preferred that the decision if the second pre-defined criterion is fulfilled and/or the second process of de-charging the control electrode is/are performed by firmware, in particular by a CPLD or by a FPGA. Firmware guaranties a short reaction time compared to software. Furthermore, it can be re-programmed in contrast to hard-wired solutions. However, hard-wired solutions are also included by the present invention.

Regarding the first process (the process of closing the valve) it is preferred that it has a latching function, i.e. that the first process closes the valve independently from the question whether the first pre-defined criterion is still fulfilled or not, once the first process has been started or once a decision to start the first process has been made. This safety measure guaranties that the closing process is terminated and no interference, noise or other circumstances may falsely stop the first process.

The second pre-defined criterion may include the criterion that the voltage between the control electrode and another electrode of the valve is in a pre-defined range which includes a value that corresponds to an excess charge of the control electrode, wherein excess charge is compared to an operating state of the valve in which the valve is fully open for carrying a maximum possible valve current during normal operation, but charge cannot be withdrawn from the control electrode without limiting the valve current. Other aspects of this embodiment were described above.

Another way of distinguishing between the first process and the second process may be the size of a current which withdraws charge from the control electrode. Preferably, the size of the current is different in the first process compared to the second process.

The present invention also includes an arrangement for operating an electronic valve in a converter, in particular a high power converter, wherein the valve comprises an electrically insulated control electrode and wherein the arrangement comprises:
- a monitoring unit adapted to monitor an operating state of the converter and/or of the valve while the valve is open,
- a drive unit adapted to perform a first process of de-charging the control electrode in order to close the valve, if the operating state fulfils a first pre-defined criterion, indicating that there is a short circuit which affects a current through the valve, and
- a drive unit adapted to perform a second process of de-charging the control electrode before the first criterion is fulfilled or before the first process is started, if the operating state fulfils a second pre-defined criterion, indicating that there may be a short circuit which affects a current through the valve.

Advantages and further embodiments of the arrangement follow from the attached claims and from the above given description of the method.

The arrangement for performing in the first process and/or the second process of discharging the control electrode in case of a short circuit, can be part of a module (i.e. a single unit) which is called "Gate Drive Unit" (GDU) in the case of a valve having a Gate. Typically, each valve in the converter has its own GDU and the GDUs controlled by a single CCU (converter control unit) or by an arrangement of CCUs. The CCU triggers the processes of switching on and off the valve during normal operation of the converter. The CCU typically comprises a computer which is controlled by software. As a result, the operation of the CCU is usually slower (having longer reaction times) compared to the GDUs which are typically made of hard wired devices and/or comprise firmware running on FPGAs or CPLDs. Therefore, the handling of short circuit situations according to the present invention is preferably performed by the GDU of the valve.

In a preferred embodiment, a control unit for controlling the process of switching on and off the valve can be designed as described in WO 00/10243 in connection with Figures 1 to 3 of the document. In this document, the control unit is called "control apparatus". Each of the valves of the converter can be controlled by an individual control unit of this type, for example. Modifications of this control unit in order to implement the present invention can easily be made by modifying the firmware of the unit.

It is therefore preferred that the control unit operates based on the principle that it comprises a programmable constant current source, i.e. a device which can be programmed to drive the current to and from the control electrode so that the current is not varying with time. Of course, it is possible to re-program the size of the current. For example, the size of the current can be programmed to have a first value during the second process of discharging the control electrode and to have at least one other value during phases of the first process of discharging the control electrode.

However, the present invention is not limited to such a method of controlling the current to and from the control electrode. In principle, there are different approaches of performing the control process for controlling the current. All these approaches can be realised in connection with the invention. For example, a voltage source with a controllable voltage can be used in combination with a resistor or a plurality of resistors, located in an electrical connection between the voltage source and the control electrode of the valve. According to another approach, a voltage amplifier with pre-programmed voltage slopes may be used.

The second process (the pre-termination process) of the present invention may be disabled during the process of switching on the valve (i.e. when the valve is switched on during normal operation). As mentioned above, a short circuit which already exists before the valve is turned on, does not lead to the same drastic the valve current as for situations in which the short circuit happens while the valve (or its free-wheeling diode) is already conducting a load current. The second process can be disabled during the switching on process, since there is more time to react to a short circuit. The valve is not yet fully open. However, the invention also covers the case that the second process is enabled during switching on the valve.

Particularly after the pre-terminating and before the final termination in case of a short circuit, an un-intended charging (i. e. a re-charging after the discharging performed by the pre-termination) happens. This is a result of the so-called Miller effect. The reason for this is that there is a considerable capacitance (called Miller capacitance), between collector and gate within the valve (in particular for an IGBT), so that - when the short circuit condition occurs in the conducting state (i.e. at low collector emitter voltage) of the valve - a capacitive current is fed (in particular directly within the chips of the module constituting the valve) to the gate when the collector voltage rises in order to prevent an increase of the valve current. For ex-ample, the Gate-Emitter voltage may rise again to above 18 V, after a discharging to the level of 11 to 12 V. Furthermore, the Miller capacitance may cause a gate charging current while the pre-termination process produces a discharging current. However, the pre-termination process still improves the situation compared to the case that no pre-termination is performed.

Examples and preferred embodiments of the invention will be described with reference to the attached drawing. The Figures of the drawing show:
- Figure 1: a phase leg comprising two valves which are connected in series, wherein a short circuit is produced by mistriggering,
- Figure 2: the arrangement shown in Figure 1, wherein a short circuit happens, because one of the valves gets damaged while the other valve carries a load current,
- Figure 3: elements of an arrangement for handling short circuit situations by monitoring the operating state of one of the valves of a phase leg,
- Figure 4: details of a control element which is part of the arrangement shown in Figure 3,
- Figure 5: the time dependent behaviour of the valve current, the voltage across the valve, the voltage between the control electrode and another electrode of the valve and of the discharging current for discharging the control electrode during a short circuit situation, according to the present invention,
- Figure 6: the time dependent behaviour of the valve current and the other electric quantities shown in Figure 5 in a short circuit situation, wherein no pre-termination process is performed.
- Figure 7: schematically the four electric quantities shown in Figure 5 in the same short circuit situation, wherein a pre-termination process is performed followed (with-out time gap) by a process of switching off the valve,
- Figure 8: schematically the short circuit situation according to Figure 6, wherein no pre-termination process is performed,
- Figure 9: schematically a short circuit situation similar to the situation shown in Figure 5 and Figure 7, but with an alternating valve current so that the pre-termination process is stopped and re-started,
- Figure 10: schematically the four quantities of Figures 5 to Figure 9 in a situation where no short circuit occurs, but a pre-termination process is started due to interference causing a false detection of a short circuit situation.

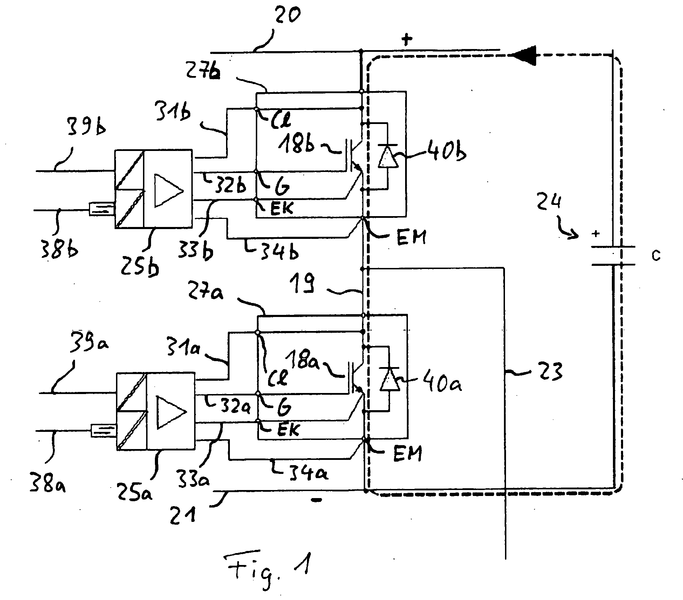

Figure 1 shows a phase leg 19 of a converter, wherein the phase leg 19 comprises a first valve 18a and a second valve 18b connected in series to each other. One end of the series connection is connected to a line 20 of a DC-link, for example a DC-link to a line converter of a propulsion unit of a railway vehicle. The opposite end of the phase leg 19 is connected to a second line 21 of the DC-link.

As shown on the right hand side of Figure 1, a capacitor 24 is connected between the lines 20, 21 of the DC-link. The electric potential of line 20 is higher than the electric potential of line 21, as marked by + and - signs. The electric connection between the valves 18a, 18b is connected to a line 23 which is a connection to a load, such as a motor, e.g. a motor which causes traction of a railway vehicle.

Figure 1 only shows parts of the converter. In particular, a control device controlling the control units 25a, 25b of the valves 18a, 18b is not shown. Furthermore, the converter may comprise one or more than one additional phase legs.

The control units 25a, 25b comprise different connections 31, 32, 33 to a module 27 containing the valve 18. In practice, such modules 27 may comprise a plurality of valves which are connected in parallel to each other.

In particular, the valve 18 may be an IGBT or a MOSFET.

The connection 31 from the control unit 25 to the collector of the valve 18 is indicated by "Cl". Connection 32 connects the control unit 25 with the control electrode, e.g. the gate of the valve 18, as indicated by "G". Connection 33 connects the control unit 25 with the other electrode on the current path of the valve 18, in particular with the emitter (Kelvin), as indicated by "EK". An external line 34, which is external to the module 27, connects the control unit 25 with an external connection point of the second electrode on the current path, e.g. with the emitter (Main), as indicated by "EM".

In the example shown, the control unit is connected to the central control device (not shown) of the converter via a signal line 38, which may be a line for transferring optical signals. Furthermore, the control unit 25 is connected to a DC-power supply via line 39.

A free-wheeling diode 40 is connected antiparallel-wise to each valve 18. Figure 1 also shows a dashed line with an arrow. The dashed line forms a closed loop indicating that a high short circuit current will develop in arrow direction, when the two valves 18a, 18b are in the ON-state at the same time. This may happen in short circuit situations of the first type, as described above.

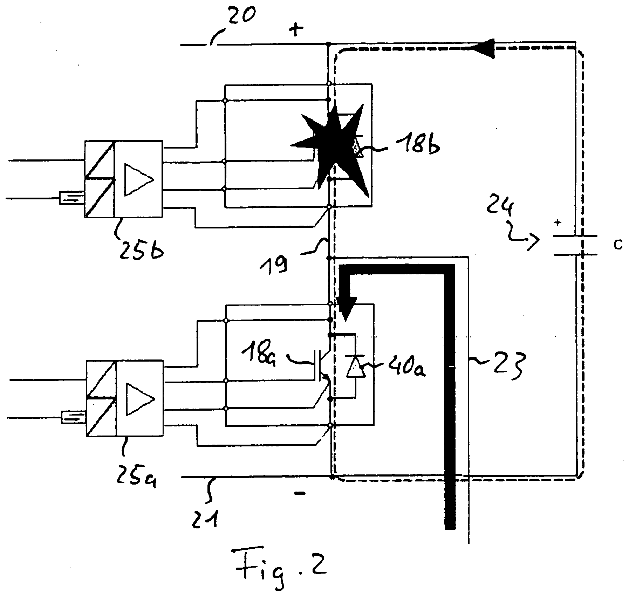

Figure 2 shows the same arrangement as Figure 1, but in a different short circuit situation, namely a short circuit situation of the second type as described above. A load current is flowing through line 23 and through valve 18a, as indicated by a solid arrowed line, while the other valve 18b gets damage, for example by a break-through of the insulation between the collector and the emitter. As a result a short circuit current through the valve 18a will rapidly increase and will destroy valve 18a, unless valve 18a is protected by rapidly discharging the control electrode and thereby limiting the increase of the short circuit current.

Similarly to the situation shown in Figure 2, the valve 18b may produce a short circuit while a current flows in the reverse direction of the solid arrowed line, i.e. the current is flowing through the free-wheeling diode 40a to line 23. This is the third type of short circuit situations and slightly later than for the second type of short circuit situations, a short circuit current through the phase leg 19 will rapidly develop. However, the reaction time which is left for discharging the control electrode is not longer compared to the second type, if the valve current through valve 18a is monitored for short circuit situations.

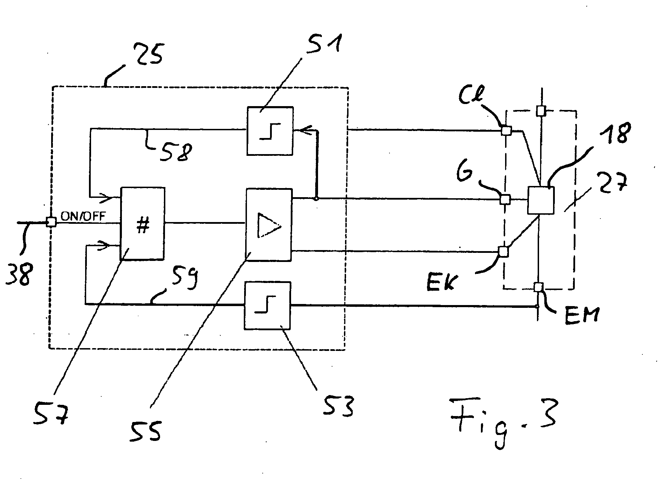

Figure 3 shows an arrangement which can be used to perform the pre-termination function according to the present invention. The Figure only shows a part of the elements and/or units of the control unit 25 which may be the control unit 25a or 25b according to Figure 1. The control unit 25 which may be realised by firmware or by hardware, comprises a control element 57 which may be a logic unit for performing logic operations. Inputs of the control element 57 are connected to the signal line 38 for receiving on/off Command signals from the converter control device. Further inputs of the control element 57 receive output signals of a first comparator 51 and of a second comparator 53. The comparator 51 is connected to the gate G and is adapted to compare the electric potential of the gate G with a threshold value. It is also possible that the voltage comparator 51 is adapted to compare the electric potential of the gate G with an upper threshold value and with a lower threshold value and to output a specific signal (such as logic "1"), if the electric potential of a gate G lies within the range between the two threshold values. In case of a single threshold value, the specific logic output signal is output from the comparator 51 to the control element 57, if the electric potential of the gate G exceeds the threshold value (or is equal to the threshold value or exceeds the threshold value).

The second comparator 53 is connected to the emitter (Main) EM of the module 27. This indicates schematically that the comparator 53 monitors the valve current and/or the increase of the valve current per time unit (the latter case is the most preferred case) and outputs a pre-defined output signal (such as logic "1") to the control element 57, if the monitored quantity exceeds a pre-defined threshold value.

On the right hand sight of Figure 3, the module 27 is shown which may be the module 27a or 27b according to Figure 1. The module 27 comprises the valve 18 which may be the valve 18a or 18b according to Figure 1.

An output of the control element 57 is connected to a driver 55 which is adapted to drive a charging or discharging current in order to charge or discharge the control electrode, which is the gate G in this case. The driver 55 is connected to the gate G and to the emitter (Kelvin) EK. This means that the charging or discharging current flows from the emitter to the gate (charging current) or from the gate to the emitter (discharging current). Usually, the gate carries a positive charge when the valve is in the ON-state. However, it is also possible that the gate carries a negative charge when the valve is in the ON-state. The signal which is transferred from the control element 57 to the driver 55 contains the information to start the dis-charging of the control electrode according to the pre-termination method of the present invention. It may also contain the information about the size of the discharging current. However, in an alternative solution, the driver 55 can obtain the information about the size of the current from another device and/or this information can be pre-programmed and the driver 55 may have access to this pre-programmed information. It is also possible that the size of the discharging current during the pre-termination varies and/or is adapted depending on the operating state of the valve or of the converter during the pre-termination.

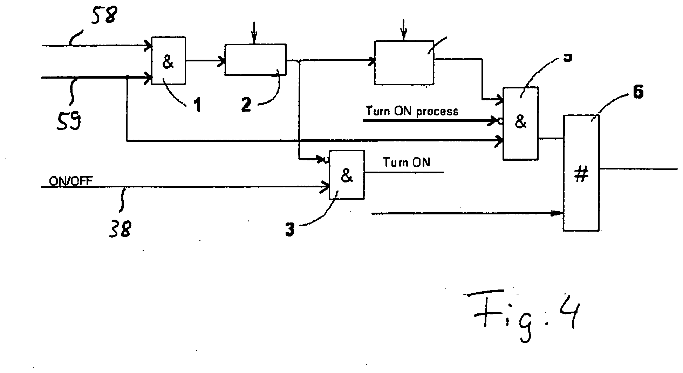

Figure 4 shows essential elements of the control element 57 according to the most preferred embodiment. However, this is just one embodiment and does not limit the invention to this embodiment.

A first logic unit 1 comprises the inputs for receiving the signals from comparators 51, 53 via signal lines 58, 59 as shown in Figure 3. For example, the specific logic signal (e.g. "1") is received via signal line 58, if the electric potential of the gate G is in the pre-defined range which indicates that there is an excess charge on the control electrode. Therefore, the excess charge can be removed from the gate or control electrode without affecting the maximum possible valve current during normal operation of the valve 18.

Via signal line 59, the first logic unit 1 may receive the specific logic signal (e.g. logic high = "1") indicating that the increase of the valve current per time unit has exceeded a threshold value. This is an indicator for a short circuit situation, especially when the valve is in the ON-state, which is indicated by the ON/OFF-signal which is received via line 38 by a second logic unit 3. However, the first logic unit 1 does not have this information.

A pre-defined output signal (e.g. logic "1") is output by the first logic unit 1 to a filter unit 2 if both input signals of unit 1 correspond to the pre-defined logic signal (e.g. "1").

Filter unit 2 is adapted to output a pre-defined logic signal (e.g. "1") if the input signal of filter unit 2 continuous to be the pre-defined logic signal over a time interval of pre-defined length. The length of this time interval can be set and can be transferred to the filter unit as indicated by the arrow above the filter unit 2. Output of filter unit 2 is connected to the second logic unit 3 and to a pulse generator 4.

The purpose of second logic unit 3 is to produce a signal indicating that the conditions for the pre-terminating procedure are fulfilled and, therefore, a kind of turning off process might be performed. The output signal of the second logic unit 3 is marked with "Turn ON". This signal is a first logic state, indicating that there is no pre-termination at present, if the output signal received from the filter unit 2 is not the pre-defined logic signal (e.g. is "0"). On the other hand, the output signal "Turn ON" of the second logic unit 3 has the other logic state, indicating that a pre-termination may occur, if the ON/OFF-signal received via line 38 indicates the "ON"-state and if the signal received from the filter unit 2 is the pre-defined logic signal. The "Turn ON"-signal can be used internally by other units or devices of the control unit 25 which are not shown in Figure 3 and Figure 4.

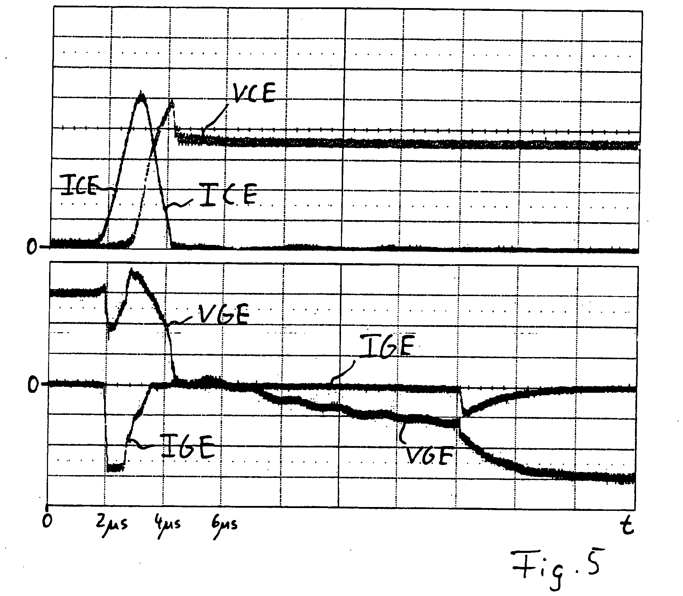

Figure 5 shows the voltage across the valve VCE, the valve current ICE, the gate-emitter voltage VGE and the gate charging current IGE as functions of time t. For the upper two graphs 0 is at the bottom of the upper half of the diagram. For the lower two graphs, 0 is at the middle of the lower half of the diagram.

Figure 5 shows a simulated short circuit situation in which one of the valves in the phase leg of a converter is replaced by a parallel connection of a plurality of valves so that a short circuit is simulated when the parallel connected valves are switched on. The four graphs show the corresponding electric quantities of the other valve in the phase leg.

At time 0, the gate potential VGE is at a level of + 15 V. This means that the valve is in its ON-state. The time scale of the diagram is chosen so that each of the rectangular blocks in the diagram has a width of 2 *µ*s. Shortly before the time 2 *µ*s, the simulated short circuit occurs. As a result, the valve current ICE is rising quickly. Since the increase of the valve current per time unit is monitored and the corresponding threshold value is exceeded shortly after the simulated short circuit, the criterion for the pre-termination process is fulfilled and, after a delay time (as implemented for example by filter unit 2 according to Figure 4) the in the range of 50 to 100 ns, in particular 60 to 80 ns, for example 70 ns, the pre-termination is started. This can be recognised by the sharp drop of the gate charging current IGE which means that the gate is discharged. The charging current IGE reaches a level of -13 V shortly after time 2 *µ*s. This means that a discharging current of 13 V is produced. This level continuous for about 600 ns. At this time, the gate potential VGE has dropped to about 9 to 10 V and has started to rise again due to the Miller capacitance. Furthermore, the voltage across the valve VCE has started rising which means that the actual process of closing the valve (switching off the valve) has been prepared. However, as can be seen in the upper half of the diagram, the valve current has not reached its maximum at time 2.7 *µ*s.

The process of pre-termination is followed by the process of switching off the valve without any time gap between the two processes. The process of switching off the valve can be recognised by looking at the development of the gate discharging current IGE which is gradually reduced (i.e. the charging current is gradually rising to level 0) while the voltage across the valve VCE is rising. This is just an example of the switching off process. Other embodiments may comprise other ways of controlling the discharging current.

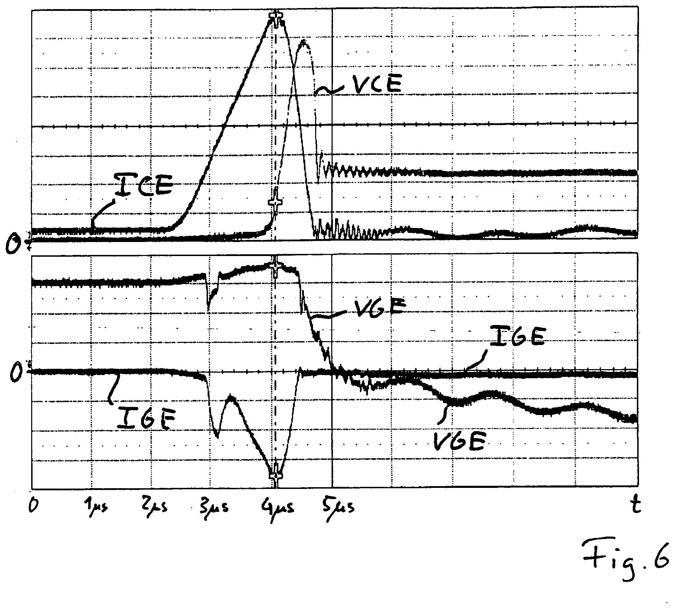

In the specific embodiment shown in Figure 5, the pre-termination process is de-signed to remove a pre-defined amount of charge from the gate by the controlled dis-charging current. However, this does not guaranty that the gate has a corresponding amount of charge removed at the end of the pre-termination, since the Miller capacitance may cause charging currents at the same time. This is actually the case, as shown by the gate potential VGE. However, the situation would be worth without the pre-termination. This will be described with reference to Figure 6.

In Figure 5, the valve current reaches its maximum at about three microseconds. At the same time, the voltage across the valve VCE starts rapidly increasing and the potential at the gate VGE is decreasing towards 0. The process of switching off has gained control over the short circuit situation and damage of the valve is prevented.

Figure 6 shows a diagram similar to Figure 5, but the time scale is different in Figure 6 (each rectangular block has a width of only one microsecond). The graphs cor-respond to a short circuit situation, wherein no pre-termination is performed. Rather, a standard process of switching off the valve is performed, only. Furthermore, the DC-link voltage is 1.200 V in the example of Figure 6 compared to 1.800 V in the ex-ample of Figure 5. Figure 6 shows that the discharging current only starts about 0.5 microseconds after the dramatic increase of the valve current which is caused by the short circuit. Furthermore, the discharging current is reduced again (at time 3.15 *µ*s), because the collector-emitter voltage VCE exceeds a threshold value of 12 V. However, this can be avoided with other strategies of switching off the valve.

Since the pre-termination is not performed, the valve current reaches a maximum value which is by 50 % higher than the maximum value in the example of Figure 5. Furthermore, the voltage across the valve VCE reaches a significantly higher maximum value (at time 4.5 *µ*s) which exceeds in the example shown the rated voltage of the valve.

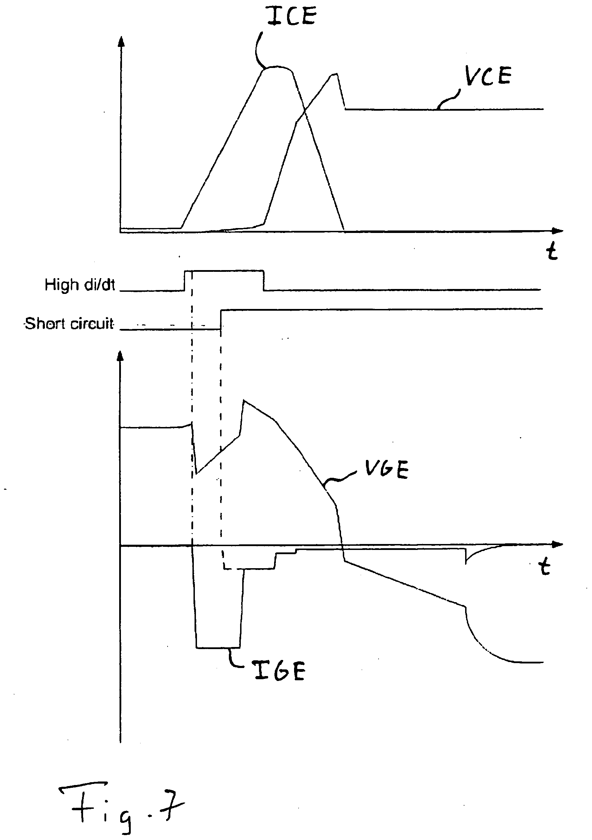

Figure 7 shows schematically the same situation as shown in Figure 5. In addition, two logic signals are shown as functions of the time t between the upper and the lower diagram of the Figure. The upper logic signal indicates whether the increase of the valve current per time unit has exceeded a pre-defined threshold value. If this logic signal is "1" (which is shown by the upper level of the step-function) the criterion for the pre-termination process is fulfilled. The lower logic signal indicates that the criterion for performing the process of switching off the valve is fulfilled or not.

When the criterion for the pre-termination process is fulfilled and a delaying time interval has terminated, the pre-termination process is started and the gate discharging current is held at a constant value until the end of the pre-termination. During the pre-termination the criterion for the process of switching off the valve becomes fulfilled. However, the pre-termination process has priority and over-rides the process of switching off the valve. Therefore, the pre-termination process is first terminated and then, without time gap, the process of switching off the valve is started.

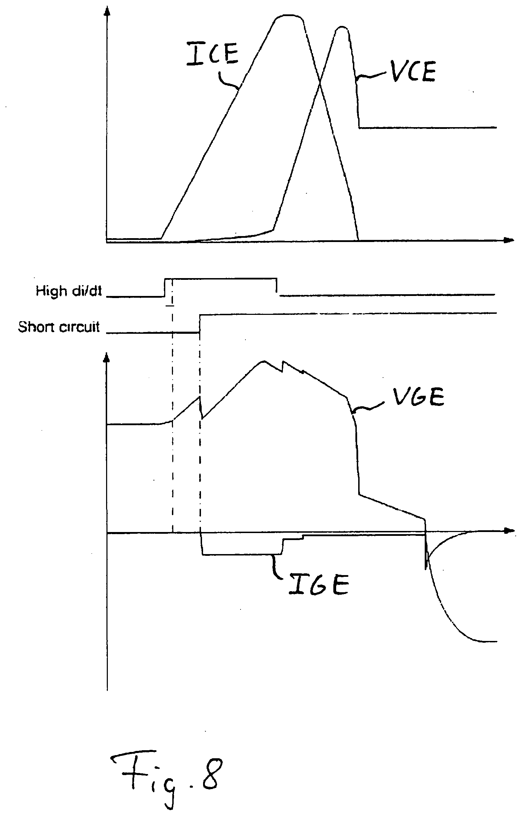

Figure 8 schematically shows the situation of Figure 6. Again, the two logic signals are shown, similarly to Figure 7, for the short circuit situation of Figure 6. However, since there is no pre-termination, the upper logic signal will not trigger a pre-termination.

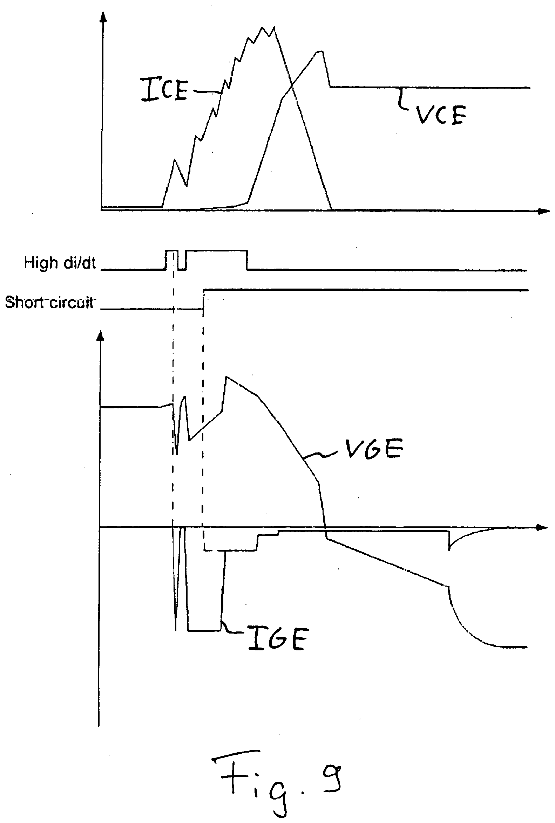

Figure 9 schematically shows a further short circuit situation wherein a pre-termination process is performed. However, compared to the situation of Figures 5 and 7, the increase of the valve current is not continuous. Rather, a first increase of the current is followed by a decrease. Despite filtering the corresponding measurement signal of the increase of the valve current per time unit, this decrease causes the pre-termination process to be interrupted as shown by the upper logic signal in Figure 9. As soon as the valve current is rising again, the pre-termination process is continued or is re-started.

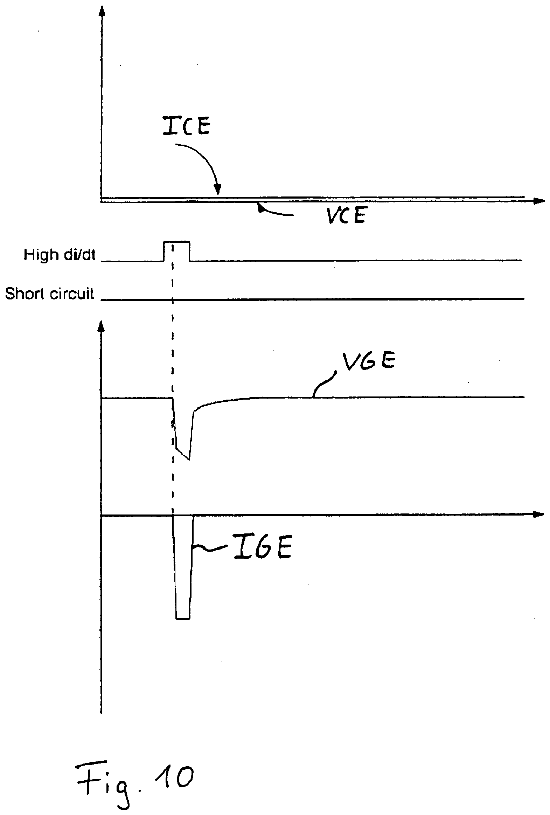

Figure 10 shows a non-short circuit situation, wherein the monitoring function of the pre-termination process is activated. The valve current ICE is constant at a level which is typical for normal operation of the valve in the ON-state.

Due to interference (for example electromagnetic induction) the logic signal indicating that the criterion for the pre-termination process is fulfilled becomes logic high and the pre-termination process is started as can be recognised from the drop of the gate charging current and the gate potential. However, since the pre-termination function does not result in a reduced valve current, the normal operation of the valve is not affected.

## Claims

1. A method of operating an electronic valve (18) in a converter, in particular a high power converter, wherein the valve comprises an electrically insulated control electrode (G) and wherein the method comprises the steps:
- an operating state of the converter and/or of the valve (18) is/are monitored while the valve (18) is in the conductive state,
- if the operating state fulfils a first pre-defined criterion, indicating that there is a short circuit which affects a current through the valve (18), a first process of de-charging the control electrode (G) is performed in order to bring the valve (18) into the non-conductive state, **characterised in that**:
- if the operating state fulfils a second pre-defined criterion, indicating that there may be a short circuit which affects a current through the valve (18), a second process of de-charging the control electrode (G) is performed before the first criterion is fulfilled or is performed before the first process is started,
- the second process does not bring the valve (18) into the non-conductive state, and
- the second pre-defined criterion is defined in such a way that the first process is accelerated if it is performed after the second process has been performed.

2. The method of claim 1, wherein the second process withdraws a pre-defined amount of charge from the control electrode (G).

3. The method of one of claims 1 to 2, wherein the second process withdraws an amount of charge from the control electrode (G) which does not reduce the current through the valve (18) during normal, non-short-circuit operating conditions of the valve.

4. The method of one of the preceding claims, wherein the second process of de-charging the control electrode (G) is performed only if the operating state fulfils the second pre-defined criterion over a time interval of pre-defined length.

5. The method of one of the preceding claims, wherein the second process of de-charging the control electrode (G) is immediately terminated if the operating state fulfils a third pre-defined criterion, indicating that there is no short circuit which affects a current through the valve (18).

6. The method of one of claims 1 to 4, wherein the second process of de-charging the control electrode (G) is terminated if the operating state fulfils a third pre-defined criterion over a time interval of pre-defined length, indicating that there is no short circuit which affects a current through the valve (18).

7. The method of one of the preceding claims, wherein the first process is a process which brings the valve (18) into the non-conductive state independently from the question whether the first pre-defined criterion is still fulfilled or not, once the first process has been started or once a decision to start the first process has been made.

8. The method of one of the preceding claims, wherein the second pre-defined criterion includes the criterion that the voltage between the control electrode (G) and another electrode (EK) of the valve (18) is in a pre-defined range which includes a value that corresponds to an excess charge of the control electrode (G), wherein excess charge is compared to an operating state of the valve (18) in which the valve (18) is fully conductive for carrying a maximum possible valve current during normal operation, but charge cannot be withdrawn from the control electrode (G) without limiting the valve current.

9. An arrangement for operating an electronic valve (18) in a converter, in particular a high power converter, wherein the valve comprises an electrically insulated control electrode (G) and wherein the arrangement comprises:
- a monitoring unit (57) adapted to monitor an operating state of the converter and/or of the valve while the valve (18) is in the conductive state,
- a drive unit (55) adapted to perform a first process of de-charging the control electrode (G) in order to bring the valve (18) into the non-conductive state, if the operating state fulfils a first pre-defined criterion, indicating that there is a short circuit which affects a current through the valve (18),
- the drive unit (55) adapted to perform a second process of de-charging the control electrode (G) before the first criterion is fulfilled or before the first process is started, if the operating state fulfils a second pre-defined criterion, indicating that there may be a short circuit which affects a current through the valve (18),
wherein the arrangement is adapted to perform the second process so that the valve (18) is not brought into the non-conductive state by the second process and the second pre-defined criterion is defined in such a way that the first process is accelerated if it is performed after the second process has been performed.

10. The arrangement of the preceding claim, wherein the arrangement is adapted to perform the second process in such a manner that a pre-defined amount of charge is withdrawn from the control electrode (G).

11. The arrangement of one of the preceding claims, wherein the arrangement is adapted to perform the second process in such a manner that an amount of charge is withdrawn from the control electrode (G) which does not reduce the current through the valve (18) during normal, non-short-circuit operating conditions of the valve.

12. The arrangement of one of the preceding claims, wherein the arrangement is adapted to perform the second process of de-charging the control electrode (G) only if the operating state fulfils the second pre-defined criterion over a time interval of pre-defined length.

13. The arrangement of one of the preceding claims, wherein the arrangement is adapted to immediately terminate the second process of de-charging the control electrode (G) if the operating state fulfils a third pre-defined criterion, indicating that there is no short circuit which affects a current through the valve (18).

14. The arrangement of one of claims 9 to 13, wherein the arrangement is adapted to terminate the second process of de-charging the control electrode (G) if the operating state fulfils a third pre-defined criterion over a time interval of pre-defined length, indicating that there is no short circuit which affects a current through the valve (18).

15. The arrangement of one of the preceding claims, wherein the arrangement is adapted to perform the first process as a process which brings the valve (18) into the non-conductive state independently from the question whether the first pre-defined criterion is still fulfilled or not, once the first process has been started or once a decision to start the first process has been made.

## Patentansprüche

1. Betriebsverfahren für ein elektronisches Ventil (18) in einem Stromrichter, insbesondere in einem Hochleistungsstromrichter, wobei das Ventil eine elektrisch isolierte Steuerelektrode (G) aufweist und wobei das Verfahren die folgenden Schritte aufweist:
- Überwachen eines Betriebszustands des Stromrichters und/oder des Ventils (18), während das Ventil (18) im leitenden Zustand ist,
- wenn der Betriebszustand ein erstes vordefiniertes Kriterium erfüllt, was anzeigt, dass ein Kurzschluss besteht, der einen Strom durch das Ventil (18) beeinträchtigt, Durchführen eines ersten Prozesses zum Entladen der Steuerelektrode (G), um das Ventil (18) in den nichtleitenden Zustand zu versetzen,
**dadurch gekennzeichnet, dass**:
- wenn der Betriebszustand ein zweites vordefiniertes Kriterium erfüllt, was anzeigt, dass möglicherweise ein Kurzschluss besteht, der einen Strom durch das Ventil (18) beeinträchtigt, ein zweiter Prozess zum Entladen der Steuerelektrode (G) durchgeführt wird, bevor das erste Kriterium erfüllt wird oder bevor der erste Prozess gestartet wird,
- der zweite Prozess das Ventil (18) nicht in den nichtleitenden Zustand versetzt und
- das zweite vordefinierte Kriterium so definiert ist, dass der erste Prozess beschleunigt wird, wenn er nach Durchführung des zweiten Prozesses durchgeführt wird.

2. Verfahren nach Anspruch 1, wobei der zweite Prozess eine vordefinierte Ladungsmenge von der Steuerelektrode (G) zieht.

3. Verfahren nach einem der Ansprüche 1 bis 2, wobei der zweite Prozess eine Ladungsmenge von der Steuerelektrode (G) zieht, die den Strom durch das Ventil (18) während der normalen Betriebsbedingungen des Ventils ohne Kurzschluss nicht reduziert.

4. Verfahren nach einem der vorhergehenden Ansprüche, wobei der zweite Prozess zum Entladen der Steuerelektrode (G) nur durchgeführt wird, wenn der Betriebszustand das zweite vordefinierte Kriterium über eine Zeitspanne vordefinierter Länge erfüllt.

5. Verfahren nach einem der vorhergehenden Ansprüche, wobei der zweite Prozess zum Entladen der Steuerelektrode (G) unmittelbar beendet wird, wenn der Betriebszustand ein drittes vordefiniertes Kriterium erfüllt, was anzeigt, dass kein Kurzschluss besteht, der einen Strom durch das Ventil (18) beeinträchtigt.

6. Verfahren nach einem der Ansprüche 1 bis 4, wobei der zweite Prozess zum Entladen der Steuerelektrode (G) beendet wird, wenn der Betriebszustand ein drittes vordefiniertes Kriterium über eine Zeitspanne vordefinierter Länge erfüllt, was anzeigt, dass kein Kurzschluss besteht, der einen Strom durch das Ventil (18) beeinträchtigt.

7. Verfahren nach einem der vorhergehenden Ansprüche, wobei der erste Prozess ein Prozess ist, der das Ventil (18) unabhängig von der Frage, ob das erste vordefinierte Kriterium noch erfüllt wird oder nicht, in den nichtleitenden Zustand versetzt, sobald der erste Prozess gestartet wurde oder sobald eine Entscheidung zum Starten des ersten Prozesses getroffen wurde.

8. Verfahren nach einem der vorhergehenden Ansprüche, wobei das zweite vordefinierte Kriterium das Kriterium beinhaltet, dass die Spannung zwischen der Steuerelektrode (G) und einer weiteren Elektrode (EK) des Ventils (18) in einem vordefinierten Bereich ist, der einen Wert enthält, der einem Ladungsüberschuss der Steuerelektrode (G) entspricht, wobei der Ladungsüberschuss mit einem Betriebszustand des Ventils (18) verglichen wird, in dem das Ventil (18) voll leitend ist zum Führen eines größtmöglichen Ventilstroms während des normalen Betriebs, aber keine Ladung von der Steuerelektrode (G) gezogen werden kann, ohne den Ventilstrom zu beschränken.

9. Betriebsanordnung für ein elektronisches Ventil (18) in einem Stromrichter, speziell einem Hochleistungsstromrichter, wobei das Ventil eine elektrisch isolierte Steuerelektrode (G) aufweist und wobei die Anordnung Folgendes aufweist:
- eine Überwachungseinheit (57), die ausgeführt ist zum Überwachen eines Betriebszustands des Stromrichters und/oder des Ventils, während das Ventil (18) im leitenden Zustand ist,
- eine Ansteuereinheit (55), die ausgeführt ist zum Durchführen eines ersten Prozesses zum Entladen der Steuerelektrode (G), um das Ventil (18) in den nichtleitenden Zustand zu versetzen, wenn der Betriebszustand ein erstes vordefiniertes Kriterium erfüllt, was anzeigt, dass ein Kurzschluss besteht, der einen Strom durch das Ventil (18) beeinträchtigt,
- wobei die Ansteuereinheit (55) ausgeführt ist zum Durchführen eines zweiten Prozesses zum Entladen der Steuerelektrode (G), bevor das erste Kriterium erfüllt wird oder bevor der erste Prozess gestartet wird, wenn der Betriebszustand ein zweites vordefiniertes Kriterium erfüllt, was anzeigt, dass möglicherweise ein Kurzschluss besteht, der einen Strom durch das Ventil (18) beeinträchtigt,
wobei die Anordnung ausgeführt ist zum Durchführen des zweiten Prozesses, so dass das Ventil (18) von dem zweiten Prozess nicht in den nichtleitenden Zustand versetzt wird, und das zweite vordefinierte Kriterium so definiert ist, dass der erste Prozess beschleunigt wird, wenn er nach Durchführung des zweiten Prozesses durchgeführt wird.

10. Anordnung nach dem vorhergehenden Anspruch, wobei die Anordnung ausgeführt ist zum Durchführen des zweiten Prozesses auf eine solche Weise, dass eine vordefinierte Ladungsmenge von der Steuerelektrode (G) gezogen wird.

11. Anordnung nach einem der vorhergehenden Ansprüche, wobei die Anordnung ausgeführt ist zum Durchführen des zweiten Prozesses auf eine solche Weise, dass eine Ladungsmenge von der Steuerelektrode (G) gezogen wird, die den Strom durch das Ventil (18) während der normalen Betriebsbedingungen des Ventils ohne Kurzschluss nicht reduziert.

12. Anordnung nach einem der vorhergehenden Ansprüche, wobei die Anordnung ausgeführt ist zum Durchführen des zweiten Prozesses zum Entladen der Steuerelektrode (G) nur dann, wenn der Betriebszustand das zweite vordefinierte Kriterium über eine Zeitspanne vordefinierter Länge erfüllt.

13. Anordnung nach einem der vorhergehenden Ansprüche, wobei die Anordnung ausgeführt ist zum unmittelbaren Beenden des zweiten Prozesses zum Entladen der Steuerelektrode (G), wenn der Betriebszustand ein drittes vordefiniertes Kriterium erfüllt, was anzeigt, dass kein Kurzschluss besteht, der einen Strom durch das Ventil (18) beeinträchtigt.

14. Anordnung nach einem der Ansprüche 9 bis 13, wobei die Anordnung ausgeführt ist zum Beenden des zweiten Prozesses zum Entladen der Steuerelektrode (G), wenn der Betriebszustand ein drittes vordefiniertes Kriterium über eine Zeitspanne vordefinierter Länge erfüllt, was anzeigt, dass kein Kurzschluss besteht, der einen Strom durch das Ventil (18) beeinträchtigt.

15. Anordnung nach einem der vorhergehenden Ansprüche, wobei die Anordnung ausgeführt ist zum Durchführen des ersten Prozesses als einen Prozess, der das Ventil (18) unabhängig von der Frage, ob das erste vordefinierte Kriterium noch erfüllt wird oder nicht, in den nichtleitenden Zustand versetzt, sobald der erste Prozess gestartet wurde oder sobald eine Entscheidung zum Starten des ersten Prozesses getroffen wurde.

## Revendications

1. Procédé de fonctionnement d'une valve électronique (18) dans un convertisseur, en particulier un convertisseur haute puissance, dans lequel la valve comprend une électrode de commande isolée électriquement (G) et dans lequel le procédé comprend les étapes suivantes :
- un état de fonctionnement du convertisseur et/ou de la valve (18) est surveillé tandis que la valve (18) est dans l'état conducteur,
- si l'état de fonctionnement remplit un premier critère prédéfini, indiquant qu'il y a un court-circuit qui affecte un courant à travers la valve (18), un premier processus de décharge de l'électrode de commande (G) est réalisé afin d'amener la valve (18) dans l'état non conducteur, **caractérisé en ce que** :
- si l'état de fonctionnement remplit un deuxième critère prédéfini, indiquant qu'il peut y avoir un court-circuit qui affecte un courant à travers la valve (18), un second processus de décharge de l'électrode de commande (G) est réalisé avant que le premier critère soit rempli ou est réalisé avant que le premier processus soit démarré,
- le second processus n'amène pas la valve (18) dans l'état non conducteur, et
- le deuxième critère prédéfini est défini de façon à ce que le premier processus soit accéléré s'il est réalisé après que le second processus a été réalisé.

2. Procédé selon la revendication 1, dans lequel le second processus retire une quantité prédéfinie de charge de l'électrode de commande (G).

3. Procédé selon l'une des revendications 1 et 2, dans lequel le second processus retire une quantité de charge de l'électrode de commande (G) qui ne réduit pas le courant à travers la valve (18) pendant des conditions de fonctionnement normal sans court-circuit de la valve.

4. Procédé selon l'une des revendications précédentes, dans lequel le second processus de décharge de l'électrode de commande (G) est réalisé uniquement si l'état de fonctionnement remplit le deuxième critère prédéfini sur un intervalle de temps de longueur prédéfinie.

5. Procédé selon l'une des revendications précédentes, dans lequel le second processus de décharge de l'électrode de commande (G) est immédiatement terminé si l'état de fonctionnement remplit un troisième critère prédéfini, indiquant qu'il n'y a pas de court-circuit qui affecte un courant à travers la valve (18).

6. Procédé selon l'une des revendications 1 à 4, dans lequel le second processus de décharge de l'électrode de commande (G) est terminé si l'état de fonctionnement remplit un troisième critère prédéfini sur un intervalle de temps de longueur prédéfinie, indiquant qu'il n'y a pas de court-circuit qui affecte un courant à travers la valve (18).

7. Procédé selon l'une des revendications précédentes, dans lequel le premier processus est un processus qui amène la valve (18) dans l'état non conducteur indépendamment de la question de savoir si le premier critère prédéfini est toujours rempli ou non, une fois que le premier processus a été démarré ou une fois qu'une décision de démarrer le premier processus a été prise.

8. Procédé selon l'une des revendications précédentes, dans lequel le deuxième critère prédéfini comporte le critère selon lequel la tension entre l'électrode de commande (G) et une autre électrode (EK) de la valve (18) est dans une plage prédéfinie qui comporte une valeur qui correspond à un excédent de charge de l'électrode de commande (G), dans lequel l'excédent de charge est comparé à un état de fonctionnement de la valve (18) dans lequel la valve (18) est totalement conductrice pour transporter un courant de valve possible maximal pendant un fonctionnement normal, mais une charge ne peut pas être retirée de l'électrode de commande (G) sans limiter le courant de valve.

9. Agencement pour faire fonctionner une valve électronique (18) dans un convertisseur, en particulier un convertisseur haute puissance, dans lequel la valve comprend une électrode de commande isolée électriquement (G) et dans lequel l'agencement comprend :
- une unité de surveillance (57) adaptée pour surveiller un état de fonctionnement du convertisseur et/ou de la valve tandis que la valve (18) est dans l'état conducteur,
- une unité de pilotage (55) adaptée pour réaliser un premier processus de décharge de l'électrode de commande (G) afin d'amener la valve (18) dans l'état non conducteur, si l'état de fonctionnement remplit un premier critère prédéfini, indiquant qu'il y a un court-circuit qui affecte un courant à travers la valve (18) ;
- l'unité de pilotage (55) adaptée pour réaliser un second processus de décharge de l'électrode de commande (G) avant que le premier critère soit rempli ou avant que le premier processus soit démarré, si l'état de fonctionnement remplit un deuxième critère prédéfini, indiquant qu'il peut y avoir un court-circuit qui affecte un courant à travers la valve (18),
dans lequel l'agencement est adapté pour réaliser le second processus de sorte que la valve (18) ne soit pas amenée dans l'état non conducteur par le second processus et le deuxième critère prédéfini est défini de façon à ce que le premier processus soit accéléré s'il est réalisé après que le second processus a été réalisé.

10. Agencement selon la revendication précédente, dans lequel l'agencement est adapté pour réaliser le second processus de manière à ce qu'une quantité prédéfinie de charge soit retirée de l'électrode de commande (G).

11. Agencement selon l'une des revendications précédentes, dans lequel l'agencement est adapté pour réaliser le second processus de manière à ce qu'une quantité de charge soit retirée de l'électrode de commande (G) qui ne réduit pas le courant à travers la valve (18) pendant des conditions de fonctionnement normal sans court-circuit de la valve.

12. Agencement selon l'une des revendications précédentes, dans lequel l'agencement est adapté pour réaliser le second processus de décharge de l'électrode de commande (G) uniquement si l'état de fonctionnement remplit le deuxième critère prédéfini sur un intervalle de temps de longueur prédéfinie.

13. Agencement selon l'une des revendications précédentes, dans lequel l'agencement est adapté pour terminer immédiatement le second processus de décharge de l'électrode de commande (G) si l'état de fonctionnement remplit un troisième critère prédéfini, indiquant qu'il n'y a pas de court-circuit qui affecte un courant à travers la valve (18).

14. Agencement selon l'une des revendications 9 à 13, dans lequel l'agencement est adapté pour terminer le second processus de décharge de l'électrode de commande (G) si l'état de fonctionnement remplit un troisième critère prédéfini sur un intervalle de temps de longueur prédéfinie, indiquant qu'il n'y a pas de court-circuit qui affecte un courant à travers la valve (18).

15. Agencement selon l'une des revendications précédentes, dans lequel l'agencement est adapté pour réaliser le premier processus en tant que processus qui amène la valve (18) dans l'état non conducteur indépendamment de la question de savoir si le premier critère prédéfini est toujours rempli ou non, une fois que le premier processus a été démarré ou une fois qu'une décision de démarrer le premier processus a été prise.
